## Europäisches Patentamt
## European Patent Office
## Office européen des brevets

(19)

(11) Veröffentlichungsnummer : **0 391 106 B1**

(12)

# EUROPÄISCHE PATENTSCHRIFT

(45) Veröffentlichungstag der Patentschrift :
08.03.95 Patentblatt 95/10

(51) Int. Cl.⁶ : **G01R 31/36**

(21) Anmeldenummer : **90104961.9**

(22) Anmeldetag : **16.03.90**

(54) **Verfahren zur Ermittlung des jeweiligen Ladezustandes einer Bleibatterie und Einrichtung zur Durchführung des Verfahrens.**

(30) Priorität : **04.04.89 DE 3910868**

(43) Veröffentlichungstag der Anmeldung :
**10.10.90 Patentblatt 90/41**

(45) Bekanntmachung des Hinweises auf die
Patenterteilung :
**08.03.95 Patentblatt 95/10**

(84) Benannte Vertragsstaaten :
**DE ES FR GB IT SE**

(56) Entgegenhaltungen :
DE-A- 3 108 844
DE-A- 3 736 481
DE-B- 2 043 660
DE-B- 2 610 536
FR-A- 2 561 391
GB-A- 2 126 735
US-A- 4 626 765

(73) Patentinhaber : **Jungheinrich
Aktiengesellschaft
Friedrich-Ebert-Damm 129
D-22047 Hamburg (DE)**

(72) Erfinder : **Kröger, Hennig, Dipl.-Ing.
Köpenicker Str. 76 a
D-2000 Hamburg 73 (DE)**

(74) Vertreter : **Dipl.-Ing. H. Hauck, Dipl.-Ing. E.
Graalfs, Dipl.-Ing. W. Wehnert, Dr.-Ing. W.
Döring
Neuer Wall 41
D-20354 Hamburg (DE)**

EP 0 391 106 B1

**Beschreibung**

Die Erfindung bezieht sich auf ein Verfahren zur Ermittlung des Ladezustands (Kapazität) einer Bleibatterie nach dem Oberbegriff des Patentanspruchs 1.

Aus der DE-A- 3 736 481 ist ein Verfahren zur Ermittlung des Ladezustandes einer Bleibatterie bekannt geworden, bei dem feste, vom Batteriehersteller ermittelte Entladestrom-Kennlinien zugrundegelegt werden. Diese sind strom- und kapazitätsabhängig. Die Abweichung der Batteriespannung von der Kennlinienspannung wird als Maß für den Batteriestrom herangezogen, der dann integriert über die Zeit die Verschiebung entlang der Kapazitätsachse ergibt. Da eine Kennlinienschar für verschiedene Entladeströme vorgesehen ist, muß für dazwischenliegende Stromwerte eine Interpretation vorgenommen werden. Weitere Verfahren zur Bestimmung der Kapazität von Bleibatterien sind in US-A-4 626 765, GB-A-2 126 735 beschrieben.

Der Erfindung liegt daher die Aufgabe zugrunde, ein Verfahren zur Ermittlung des Ladezustands einer Bleibatterie anzugeben, das wechselnde Lastzustände berücksichtigt und nur auf der Messung von Klemmspannungswerten beruht.

Diese Aufgabe wird durch die Merkmale des Patentanspruchs 1 gelöst.

Bei dem erfindungsgemäßen Verfahren werden die vorgegebenen Kennlinienwerte von Spannungswerten gebildet, die experimentell durch Messung der Batteriespannung kurz nach Abnahme einer Belastung ermittelt wurden. Die gemessene Spannungsdifferenz zwischen der Klemmenspannung vor einer Lastaufschaltung und der Klemmenspannung unter Last wird von einem vorgewählten Kennlinienwert substrahiert. Der erhaltene Vergleichsspannungswert wird mit einem gemessenen Spannungswert unter Last verglichen, und bei einer erneuten Messung wird ein anderer vorzugsweise benachbarter Kennlinienwert gewählt, wenn die Abweichung ungleich Null ist, wobei sich der Ladezustand als der zum gewählten Kennlinienwert gehörige Kapazitätswert bestimmt.

Beim erfindungsgemäßen Verfahren wird ausschließlich die Klemmspannung gemessen. Abweichend vom Stand der Technik sind jedoch die Kennlinienwerte in einem Speicher abgelegt, und zwar von einer einzigen Kennlinie für Spannungswerte, die unmittelbar nach Abschaltung einer Last vor Erreichen der Ruhespannung auftreten. Diese Kennlinie läßt sich (an diskreten Punkten) experimentell ermitteln. Es ist jedoch nicht notwendig, für jede Batterie bzw. für Batterien unterschiedlicher Kapazität eine derartige Messung vorzunehmen, weil bekanntlich Batterien aus Zellen aufgebaut sind, welche wiederkehrende Betriebswerte aufweisen. Kennt man daher die Kennlinie für eine Zelle, kennt man daher auch die Kennlinie für eine beliebige aus einer beliebigen Anzahl von Zellen aufgebauten Bleibatterie.

Bekanntlich weicht der Kennlinienverlauf unmittelbar nach Lastabschaltung von der Kennlinie der Ruhespannung ab. Ferner haben die Kennlinien für die Ruhespannung und die für 2 Minuten nach Lastabschaltung ebenfalls eine Differenz, die erfindungsgemäß für Messungen herangezogen wird. Wird eine Last zugeschaltet, ergibt sich ein Spannungseinbruch, so daß eine Klemmspannungsdifferenz ermittelt werden kann. Der gefundene Spannungswert bei Lastzuschaltung ist jedoch nicht derjenige, der einer bestimmten Kennlinie bei dieser Last entspricht. Es wurde jedoch gefunden, daß dieser Kennlinienwert erhalten werden kann, wenn die ermittelte Spannungsdifferenz von dem abgespeicherten Kennlinienwert subtrahiert wird. Bei dem erfindungsgemäßen Verfahren wird daher der gemessene Spannungswert unter Last mit dem Spannungswert verglichen, der durch Subtraktion der Spannungsdifferenz von dem gespeicherten Kennlinienwert erhalten wird. Der zum Vergleich herangezogene Kennlinienwert kann zunächst beliebig sein, bis eine Annäherung erfolgt derart, daß die Differenz gleich oder annähernd Null ist. In der Praxis wird sich jedoch ein anderer Verfahrensverlauf ergeben. Bei voll beladener Batterie kann unterstellt werden, daß der zugehörige Kennlinienwert dem höchsten gespeicherten Kennlinienwert entspricht, der die Volladung repräsentiert. Bei fortschreitender Entladung wird jedoch eine Differenz auftreten zwischen dem höchsten Kennlinienwert und der gemessenen Spannung, so daß im Anschluß der Vergleich mit einem vorzugsweise nächstniedrigen Kennlinienwert fortgesetzt wird. Der aus dem Speicher auf diese Weise abgerufene sich ändernde Wert repräsentiert den Ladungszustand.

In den Ansprüchen 2 bis 7 sind vorteilhafte Ausgestaltungen des erfindungsgemäßen Verfahrens angegeben.

Der Anspruch 8 stellt auf eine vorteilhafte Vorrichtung zur Durchführung des erfindungsgemäßen Verfahrens ab. Die Ansprüche 9 bis 14 sind vorteilhafte Ausgestaltungen der erfindungsgemäßen Vorrichtung.

Im folgenden wird die Erfindung anhand von Ausführungsbeispielen erläutert, die im Bereich von Kennlinien das Verfahren erläutern und im Falle der Blockschaltbilder und Schaltungen besonders vorteilhafte Ausgestaltungen zeigen.

Fig. 1            ein Kurvenbild mit verschiedenen Belastungskurven für eine Batterie, wobei erfindungsgemäß eine Bezugslinie und die Ruhekennlinie eingezeichnet sind;

Fig. 2            eine Teilansicht aus Fig. 1 zur Erläuterung der Funktion;

Fig. 3      eine Teildarstellung aus Kurvenscharen in einem Ordinatensystem, auch nach den Fig. 1 und 2 zur Erläuterung der erfindungsgemäßen Lösung zwecks Erstellung einer aktuellen verschobenen Bezugslinie;

Fig. 4      eine Einzeldarstellung zur Erläuterung eines besonderen Zustandes mit Ermittlung eines Bezugswertes;

Fig. 5      ein Blockschaltbild für die Anordnung einer Batterie an einer Recheneinrichtung unter Erläuterung der dafür maßgeblichen Bestandteile;

Fig. 6 a b c      in der Buchstabenreihenfolge von links nach rechts aneinandergelegt ein Blockdiagramm als Schaltung die Durchführung des Verfahrens

Fig. 7      eine räumliche, perspektivische Prinzip-Darstellung für die Speisung einer Anzeigevorrichtung, wie sie für die Erfindung vorteilhaft ist.

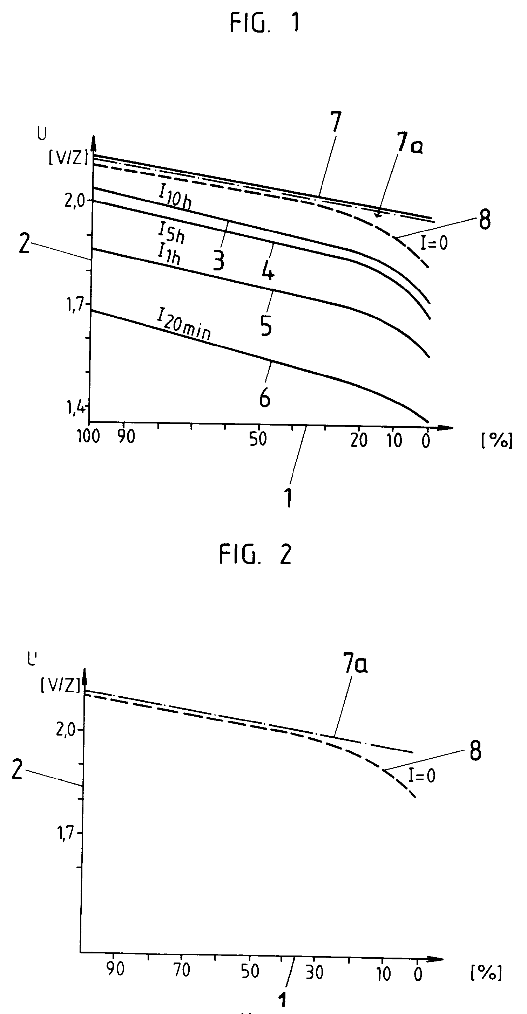

In den Fig. 1 bis 4 ist jeweils ein Koordinatensystem gezeigt, dessen Abszisse 1 in der Größenordnung der Kapazität mit Maßangabe (Prozent) einteilig ist und deren Ordinate 2 jeweils die Größenordnung der Spannung $U_{batt.}$ (dargestellt in V/Z) aufweist.

Die Abszisse ist in Werten der Kapazität einer Batterie mit 10 % Verfügbarkeit an der Stelle parallel zu der Ordinate und mit Erlöschen auf 0 % am rechten Rand der Abszisse dargestellt. Dieses ist schon von Bedeutung, und zwar auch im Hinblick auf Belastungskennlinien, beispielsweise 3 bis 6, welche zwar nur verschiedene Belastungsströme

$$I_{10\ h};\ I_{5\ h};\ I_{1\ h};\ I_{20\ min.}$$

kennzeichnen und für jede einzelne Batterie geliefert werden.

Dabei kommt zum Ausdruck, daß bei der jeweiligen Kapazität ein besonders angegebener Strom über eine gewisse Zeitdauer aufrechterhalten wird.

Unterhalb einer Ruhekennlinie 7, die nach einer Abschaltung der Last nach einer Zeit länger als eine Stunde gebildet wird, befindet sich eine Bezugslinie 8, die an Ihrem Ende stark abfällt. Während die Ruhekennlinie 7 bekannt ist, wird eine Ruhelinie 7a zusätzlich dadurch gebildet, daß sie aus Meßwerten nach 120 sec nach einer Lastabschaltung gebildet wird.

Fig. 2 zeigt die Ruhelinie 7 a und die Bezugslinie 8. In weitgehendem Entladezustand der Batterie ergibt sich dabei eine zunehmende Abweichung. Während die Ruhekennlinie 7 und die Belastungskennlinien 3 - 6 für die Batterie üblich sind, bildet, außer der Ruhelinie 7 a, die Bezugslinie 8 eine eigens erarbeitete Bezugsgröße, die in besonderer Weise für jeweils gleichartige Bleibatteriearten ermittelt wird.

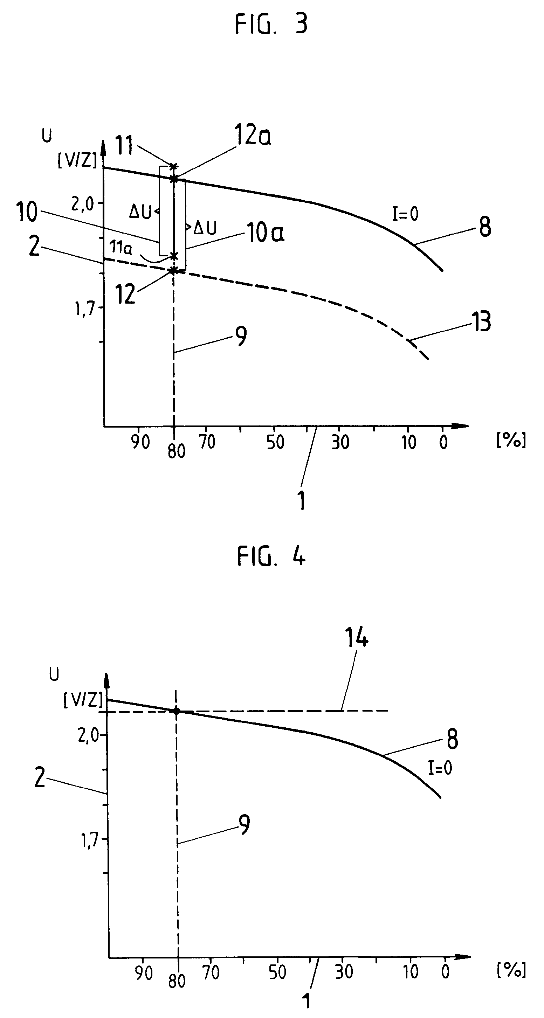

In der Fig. 3 ergibt sich ein besonderes Merkmal der Erfindung. Dabei ist die Bezugslinie 8 mit einer Belastung I = 0 gezeichnet. Eine beispielhafte Messung findet gemäß der angegebenen Darstellung beim Kapazitätswert 80 entsprechend der gestrichelten Linie 9 statt. Wenn auch vorher erst einmal die Bezugslinie zu bestimmen war, so ist diese gemäß Fig. 3 vorausgesetzt, wobei dann bei einer Lastaufschaltung aus einem vorher abgeschalteten Zustand ein Spannungssprung 10 in der Größenordnung $\Delta$ U erfolgt und in diesem Zusammenhang ein unterer Spannungswert 11 a erreicht wird. Dieser Spannungssprung, ausgehend vom oberen Spannungswert 11, ergibt sich durch die Lastaufschaltung und daraus, daß in kürzester Zeit, und zwar in der Größenordnung von 5 - 200 msec., insbesondere unterhalb von 100 msec. ein Wert gemessen wird. Der Spannungswert 11 über der Bezugslinie 8 entsteht dadurch, daß die Batterie aufgrund von Erholungszeiten vor der Lastaufschaltung einen höheren Spannungswert angenommen hat.

Die sich durch die Lastaufschaltung ergebende Differenz $\Delta$ U zwischen den Spannungswerten 11 und 11 a wird wertmäßig von dem Wert der Bezugslinie, welcher den Schnittpunkt mit der gestrichelten Linie 9 ergibt, abgezogen und stellt den Punkt 12 in Fig. 3 dar. Durch diesen neuen Spannungswert wird die aktuelle Last-Bezugslinie 13 gezogen. Sie bildet nun die neue Bezugslinie unter Belastung für die weiteren Betrachtungen, solange dieser Belastungszustand unverändert vorliegt.

Das Verschieben der Bezugslinie um ein bei einer Lastaufschaltung ermitteltes $\Delta$ U 10, jedoch nicht auf den Ausgangswert 11 vor der Belastung bezogen, sondern von der Bezugslinie 8 im Schnittpunkt liegenden Wert 12 a um das größengleiche $\Delta$ U 10a in den Punkt 12, ist ein wesentliches Merkmal der Erfindung.

Bei der nächstfolgenden Lastabschaltung, der kein Zeitlimit gesetzt ist und nur vom Belastungszyklus (bezügl. eines Flurförderzeuges beispielsweise für die Betriebszustände Heben und Fahren) abhängig ist, wird ein integrierter Spannungswert Ue, der sich aus z. B. zehn Einzelmeßwerten ergibt, die in z. B. 100 msec. Abtastrate gemessen wurden, mit der Bezugslinie 8 verglichen und geprüft, ob sich eine Kapazitätsänderung ergeben hat.

Durch die Messung innerhalb einer sehr kurzen Zeit, insbesondere in der Größenordnung von 100 msec., wird der steile Abschnitt eines entstehenden Spannungsverlaufs ohne den sich daran anschließenden Kurvenverlauf mit asymptotischer Annäherung an die Ruhekennlinie erfaßt. Daraus ergibt sich durch den gewonnenen Endpunkt dann der Wert für den Verlauf der Bezugslinie 8. Hierbei wird die Feststellung noch dadurch verfeinert, daß solche Messungen auch mit Interpolationen für verschiedene eng benachbarte Meßwerte im Bereich eines Meßwert-Zeitpunktes bezüglich einer Stufe der Kapazität im Verlauf der Batterie-Entladung vorgenommen wird. Der Verlauf der aktuellen Lastlinie, bzw. Bezugslinie 13 ergibt sich dadurch, daß für eine Vielzahl der Batteriekapazitäten mit gleichmäßigem Abstand der Spannungssprung 10 bei Lastaufschaltung und die Spannungserhöhung nach einer Lastabschaltung gemessen werden.

Die so ermittelte aktuelle Lastlinie 13 stellt nicht nur den jeweiligen Batteriezustand dar, sondern verlagert sich anpassungsfähig an jeweilige Bedingungen, vor allem an jeweilige Lastbedingungen, die sich von Fall zu Fall ändern können, so daß die verlagerte bzw. verschobene Bezugslinie bzw. aktuelle Lastlinie einen wahren Rückschluß zuläßt.

In Fig. 4 ist beispielhaft gezeigt, wie für eine Batteriekapazität von 80 % unter obigen Gesichtspunkten ein Schnittpunkt mit der parallel zur Abszisse verlaufenden Linie 14 gewonnen wird, welche die Batteriespannung bei abgeschalteter Belastung, d. h. I = 0 darstellt, wobei eine Zeitkonstante für die Abschaltung einbezogen wird, die insbesondere unter 100 m/sec. liegt. Auch in dieser Weise wird die Bezugslinie 8 ohne Belastung bzw. mit dem Strom I = 0 festgestellt.

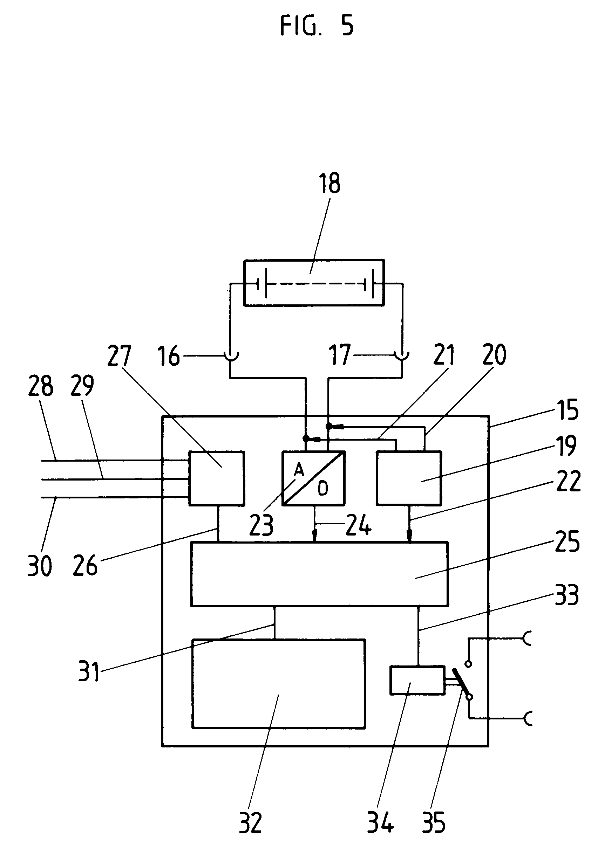

Die Fig. 5 zeigt ein Prinzip blockschaltbildend für den Entladewächter. Dieser ist in einer Baugruppe 15 untergebracht. Diese Baugruppe 15 hat zwei Anschlußklemmen 16, 17 zum Anschluß einer Batterie 18. Innerhalb der Baugruppe des Entladewächters ist eine Versorgungseinheit 19 vorgesehen, welche über Zuleitungen 20, 21, bzw. 22 die im Entladewächter vorhandenen Teile speist. An die Anschlußklemmen 16, 17 ist ein A/D, d. h. Analog/Digitalwandler 23 angeschlossen, der über eine Funktionsverbindung 24 mit einem Mikroprozessor 25 verbunden ist, in welcher besondere Schaltungen zur Ermittlung des Ergebnisses angeordnet sind.

Ein weiterer Eingang 26 in den Mikroprozessor 25 kommt von einer logischen ODER-Schaltung 27 mit drei Eingängen 28, 29, 30. Die Eingänge 28 bis 30 sind mit Verbrauchern verbunden, von denen einer gezeigt ist. Diese Verbraucher bilden unterschiedliche Belastungszustände, die damit erfaßt werden. Der Eingang 28 kann mit einem Motor für die Vorwärtsfahrt eines Flurförderzeuges, der Anschluß 29 für die Rückwärtsfahrt eines solchen Flurförderzeuges und der Anschluß 30 mit einem Motor für den Hubantrieb eines Flurförderzeuges vorgesehen sein, so daß jeweils die spezielle Art der Belastung an die ODER-Schaltung angelegt wird. Diese bildet ein Signal bei Belastung eines oder aller drei Eingänge. Dieses Signal wird an den weiteren Eingang 26 in den Mikroprozessor 25 weitergegeben. In diesem erfolgt dann letzten Endes auch unter obigen Gesichtspunkten eine Auswertung, die über eine Funktionsverbindung 31 zu einer LCD-Anzeige 32 weitergegeben wird.

Zusätzlich wird bemerkt, daß an den Mikroprozessor 25 Funktionsleitungen 33 zu einem Relais 34 mit einem Schalter 35 angeschlossen ist, welcher dann betätigt wird, wenn bei einer abgefallenen Batteriekapazität auf etwa 20 % die Möglichkeit eines Hubes im Flurförderzeug unterbrochen oder ausgeschaltet wird.

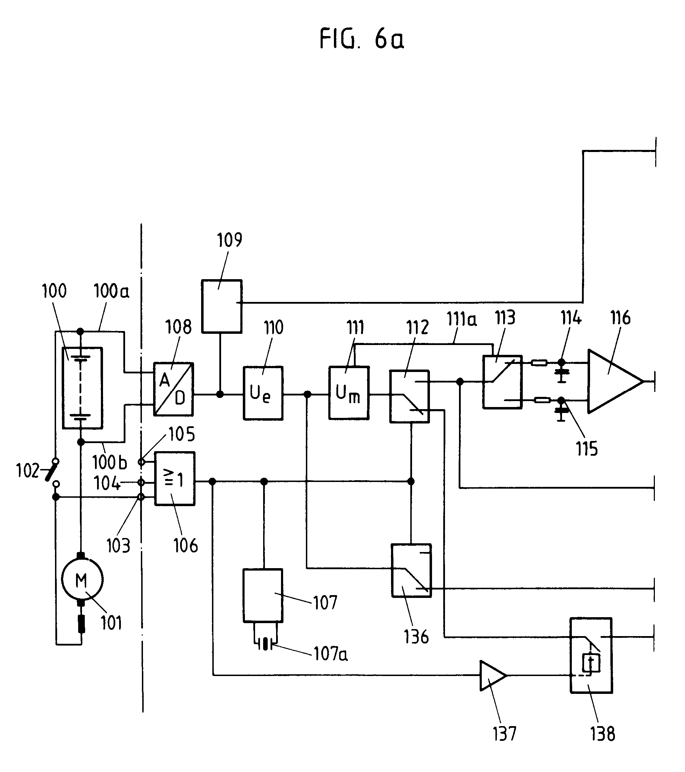

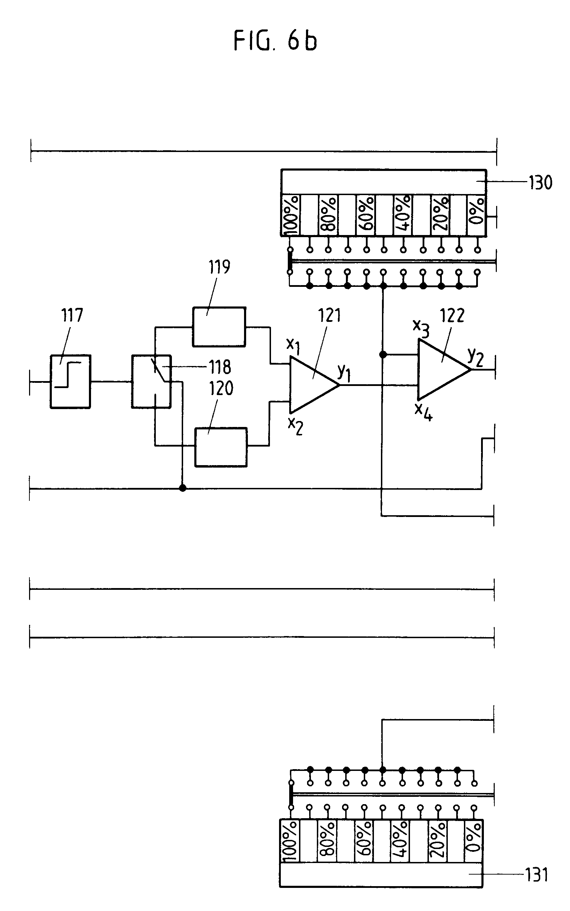

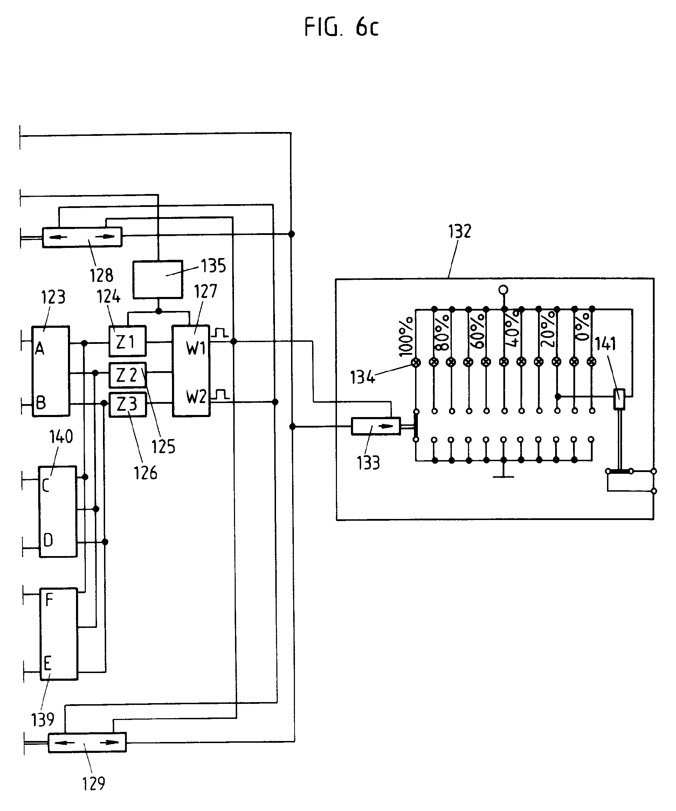

Fig. 6 zeigt ein mehr ins Einzelne gehendes Schaltbild für eine Einrichtung zur Messung der Kapazität während einer Batterieentladung.

Eine Batterie 100 ist mit einer beispielhaften Motorlast 101 gezeigt, die über einen Schalter 102 zugeschaltet werden kann. Die Batteriespannung wird über die Leitungen 100 a und 100 b gemessen und in einem Analog/Digitalwandler 108 (entsprechend 27 in Fig. 5) gewandelt, so daß alle 100 msec. ein neuer gewandelter Batteriespannungswert vorliegt. In dem Analog/Digitalwandler ist ein Zeittaktgeber enthalten. Eine Rückstellschaltung 109 mit Vergleichsschaltung ist in der Lage, beim Überschreiten eines Grenzwertes am Ausgang von 108 später noch beschriebene Schrittschalter 128, 129 und 133 in ihre Ausgangslage zu bringen. Diese stellt den Anzeigewert für 100 %ige Kapazität dar.

Eine Anzahl, vorzugsweise zehn, A/D-Werte aus dem Analog/Digitalwandler 108 werden in einem Integrator 110 zu einem Spannungsintegrationswert Ue zusammengefaßt und aus einer Anzahl, vorzugsweise zehn, Spannungsintegrationswerten Ue wird ein Mittelwert Um im Mittelwertsbildner 111 gebildet. An einem logischen ODER-Verknüpfungsglied 106 mit Eingängen 103, 104 und 105 sind diese mit den Belastungen in Form der Motorlast 101 verbunden. An den Eingängen werden die Belastungen beispielsweise eines Flurförderzeugs abgefragt. Die Motorlast 101 liefert durch den Schalter 102 ein Signal, welches ein mit einem Quarz 107 a gesteuertes Zeitzählwerk 107 zur Erfassung der Betriebsstunden in Gang setzt und die Schalter 112 und 136 ansteuert. Der Schalter 112, welcher durch das aktive ODER-Glied 106 betätigt wird, zeigt damit an, daß eine Lastaufschaltung vorliegt. Über den Schalter 112 werden die gemittelten Meßwerte Um über einen Wechselschalter 113 wechselweise auf einen von zwei Zwischenspeichern 114 und 115 gelegt. Das Zeitverhalten des Mittelwertbildners 111 und des Schalters 112 sind so ausgelegt, daß der erste Meßwert Um, der nach einer Lastaufschaltung übertragen wird, noch der Spannungswert ist, der vor der Lastaufschaltung vorlag.

Auslöser für den Wechselschalter 113 ist das Vorliegen eines neuen Wertes im Mittelwertsbildner 111 über eine Funktionsleitung 111 a. Im Subtrahierglied 116 werden die Meßwerte aus den Zwischenspeichern 114, 115 voneinander subtrahiert und auf einen Komparator 117 gegeben, welcher bei einem Schwellwert größer 0,01 Volt pro Zelle den Schalter 118 auf einen jeweiligen anderen Speicher 119 und 120 umschaltet. Somit gelangen in die Speicher 119 und 120 gemittelte Meßwerte Um aus dem Mittelwertsbildner 111 über den Schalter 112. Durch Subtraktion in einer weiteren Subtrahierschaltung 121 erhält man aus den Speicherinhalten 119 und 120 das gesuchte $\Delta$ U bei der Lastaufschaltung und bei Laständerungen. Dieser $\Delta$ U-Wert wird in einem weiteren Subtrahierer 122, der über eine Schrittschaltervorrichtung 128 den aktuellen kapazitätsangepaßten Bezugswert aus dem Bezugslinienspeicher 130 erhält, abgezogen. Der so erhaltene Wert stellt die unter Last verschobene Bezugslinie dar, die nun in einem Vergleicher 123 mit dem Wert Um am Eingang B des Vergleichers verglichen wird.

Entsprechend dem Ergebnis des Vergleichers werden diese Ereignisse in den Zählern Z 1, 124 mit den Eingängen A und B bei A > B; Z 2, 125 bei A = B und Z 3, 126 bei A < B gezählt.

Ausgelöst durch einen Zeitrastgeber 135 wird nach Ablauf eines Zeitrasters, welches beispielsweise kapazitätsabhängig 540 sec. oder 180 sec. lang ist, im Signalumsetzer 127 entsprechend dem Zähler mit dem höchsten Zählerstand ein Signal wie folgt bereitgestellt. Hat der Zähler Z 1, 124 den höchsten Stand, so werden die Schrittschalter 128, 129, 133 auf einen kleineren Kapazitätswert gestellt. Hat der Zähler Z 2, 125 den größen Wert, ist die ermittelte Kapazitätsanzeige korrekt und behält ihren Wert.

Im Falle, daß der Zähler Z 3, 126 den höchsten Wert besitzt, werden die Schrittschalter 128, 129 in kapazitätsaufsteigende Richtung geschaltet. Der Schrittschalter 133 für die Anzeigeeinheit 132 wird nicht angesprochen und verharrt in dem angezeigten Zustand. Anschließend werden die Zählerinhalte durch den Zeitrastergeber 135 gelöscht.

Entsprechend den Schrittschalterstellungen werden die Werte aus dem Bezugslinienspeicher 130 und dem Ruheliníenspeicher 131 zum Vergleich herangezogen.

Entsprechend der Stellung des Schrittschaltwerkes 133 wird der aktuelle Kapazitätszustand in der Anzeigeeinheit 132 durch die Anzeigeelemente 134 angezeigt.

Bei einer Kapazitätsanzeige = 20 % wird ein Relais 141 zusätzlich betätigt. Hiermit wird ein nicht dargestellter Hubmotor aus Sicherheitsgründen abgeschaltet.

Werden alle Belastungen an der Batterie abgeschaltet, welches durch einen Signalwechsler am ODER-Glied 106 bemerkt wird, fällt der Schalter 136 in seine eingezeichnete Ruheposition und gibt den Meßwert Ue aus dem Integrator 110 auf den Vergleicher 140, der diesen Abschaltwert am Eingang D mit dem direkten Bezugslinienwert am Eingang C vergleicht und in die entsprechenden Zähler 124, 125 und 126 einträgt (Vergleich mit der Bezugslinie bei Lastabschaltung).

Über einen Inverter 137 wird ein zeitverzögernder Schalter 138 nach 120 sec. kurzzeitig angesteuert (Ruhelinie), so daß einmalig der Mittelwert Um aus dem Mittelwertsbildner 111 über den Schalter 112 auf einen weiteren Vergleicher 139 gelegt wird, der diesen Wert entsprechend der Stellung des Schrittschalters 129 mit dem Wert des Ruhelinienspeichers 131 vergleicht und entsprechend in die Zähler 124, 125 und 126 einträgt. Die Eintragungen durch die Vergleicher 123, 140 und 139 haben unterschiedliche Gewichtungen.

Anzeigeelemente 134 in der Anzeigeeinheit 132 können sowohl als Lampen, Luminizenzdioden oder LCD-Segmente (Balken) ausgebildet sein.

Die Fig. 6 enthält für die Durchführung des Verfahrens besonders vorteilhafte Merkmale in der Zuordnung der Schaltelemente und Schaltbaugruppen.

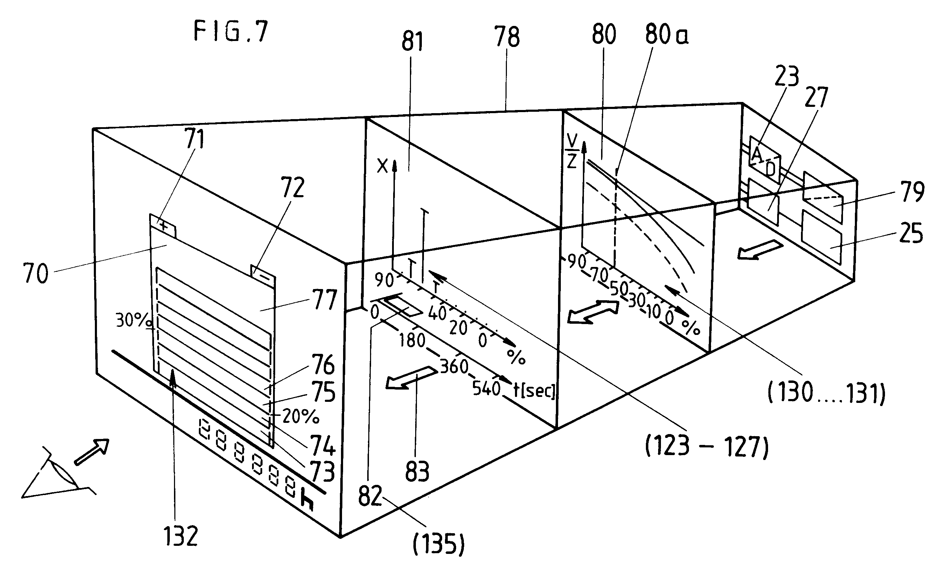

Fig. 7 zeigt schematisch eine Anzeigevorrichtung mit einem Anzeigefeld 70. Dieses Anzeigefeld hat Symbole 71, 72 für die Verdeutlichung eines Batterieanschlusses und ist im übrigen in Balkenfelder 73 ...75, 76... als Symbole für Anzeigeelemente 134 aufgeteilt. Diese Balkenfelder decken an sich das Sichtfeld 77 bei vollgeladener Batterie ab. Beispielsweise handelt es sich dabei dann um zehn Anzeigefelder. Diese werden nach Maßgabe der Batterieentladung gelöscht, wobei gem. obigen Darstellungen ein Löschungsschritt immer durch Vergleichsmessungen auch im Zusammenhang mit der Ermittlung einer interpolierten Spannung für jeden Meßschritt erfolgt. Die Anordnung eines solchen Anzeigefeldes wird für vorteilhaft gehalten.

Unter Bezugnahme auf Fig. 5 ist in der insgesamt mit 78 bezeichneten Vorrichtung nach Fig. 7 ein schaltungsmäßiger Eingang vorgesehen, welcher den Analog/Digitalwandler 23 im Anschluß an die Batterie enthält. Aufgrund verschiedener Messungen wird in einer Schaltungsbaugruppe 79 (110, 111 in Fig. 6) die Integration und Mittelwertsbildung der Meßwerte erzeugt.

Eine weitere Baugruppe entsprechend 27 in Fig. 5 (bzw. 106 in Fig. 6) hat die drei Eingänge 28 bis 30 und den Ausgangsanschluß zur Auswertungseinrichtung 25 entsprechend Fig. 5 in der Ausführung als Mikroprozessor, mit welchem auch die Schaltungsbaugruppe 79 verbunden ist, bzw. entsprechend den nachgeschalteten Baugruppen in Fig. 6.

In der folgenden Verfahrensstufe 80 werden dann die Kurvenschalen in einem Ordinatensystem gebildet, wie es prinzipiell aus Fig. 3 hervorgeht, wobei eben jeweils die Ruhelinie 7 a und die Bezugslinie 8 dargestellt sind. Die Bezugslinie kann im Bezug zur Ordinate V/Z verschoben werden. Aus der Abszisse werden in der beschriebenen Weise die Werte jeweils für eine Kapazität entnommen.

Daraus ergibt sich in einer weiteren Verfahrensstufe 81, symbolisch durch eine Ebene 81 dargestellt, über der jeweiligen Batteriekapazität die Wiedergabe verschiedener Werte. Eine Integration solcher Werte, abhängig von einem Zeitraster 82, führt dann gem. Funktionspfeil 83 zu einer Rückschaltung der Anzeigevorrichtung, d. h. zu einer Löschung des Feldes, wenn integrierte Messungen für eine Entladung zu einer entsprechenden Kapazitätsverminderung geführt haben. Parallel hierzu wird entsprechend die Schnittpunktlinie 80 a in der Verfahrensstufe 80 auf den neuen Kapazitätswert mitgeführt.

**Patentansprüche**

1. Verfahren zur Ermittlung des Ladezustands einer Bleibatterie, bei dem die Klemmenspannung der Batterie zu definierten Zeitpunkten und unter unterschiedlichen Belastungszuständen abgetastet und mit vorgegebenen gespeicherten Kennlinienwerten der Batteriespannung in Abhängigkeit von Kapazität verglichen wird, dadurch gekennzeichnet, daß die vorgegebenen Kennlinienwerte von Spannungswerten (8) gebildet werden, die experimentell durch Messung der Batteriespannung, die kurz nach Abnahme einer Belastung ermittelt wurden, und dadurch daß
   eine gemessene Spannungsdifferenz ($\Delta U$) zwischen der Klemmenspannung vor einer Lastaufschaltung und der Klemmenspannung unter Last von einem vorgewählten Kennlinienwert (12a) subtrahiert wird, der erhaltene Vergleichsspannungswert (12) mit einem gemessenen Spannungswert (Um) unter Last verglichen und bei einer erneuten Messung ein anderer vorzugsweise benachbarter Kennlinienwert gewählt wird, wenn die Abweichung ungleich Null ist, wobei sich der Ladezustand als der zum gewählten Kennlinienenwert gehörige Kapazitätswert bestimmt.

2. Verfahren nach Anspruch 1, dadurch gekennzeichnet, daß im Abstand von etwa 100 ms mehrere Spannungswerte gemessen werden, aus denen ein Mittelwert (Ue bzw. Um) gebildet wird.

3. Verfahren nach Anspruch 1 oder 2, dadurch gekennzeichnet, daß die Spannungsdifferenz ($\Delta U$) nur dann auf das Maß der Änderung der Lastspannung (Um) verändert wird, wenn sie einen vorgegebenen Schwellwert überschreitet.

4. Verfahren nach einem der Ansprüche 1 bis 3, dadurch gekennzeichnet, daß die Batteriekapazität in Kapazitätsstufen (100% bis 0%) unterteilt wird und die Kennlinienwerte den Kapazitätsstufen zugeordnet sind.

5. Verfahren nach einem der Ansprüche 1 bis 4, dadurch gekennzeichnet, daß diejenigen kapazitätsabhängigen Ruhespannungswerte ebenfalls gespeichert werden, die durch Messung 120 s nach Lastabschaltung gewonnen werden und mit 120 s nach Lastabschaltung gemessenen Ruhespannungswerten (Um) verglichen werden und ein anderer Kennlinienwert gewählt wird, wenn die Abweichung ungleich Null ist.

6. Verfahren nach einem der Ansprüche 1 bis 5, dadurch gekennzeichnet, daß die nach Lastabschaltung gemessene Spannung mit gespeicherten Kennlinienwerten verglichen wird und ein anderer Kennlinienwert gewählt wird, wenn die Abweichung ungleich Null ist.

7. Verfahren nach einem der Ansprüche 1 bis 6, dadurch gekennzeichnet, daß ein erster Meßzyklus nach etwa 450 Sekunden erfolgt und weitere Meßzyklen nach Ablauf von 180 Sekunden ablaufen.

8. Vorrichtung zur Durchführung des Verfahrens nach einem der Ansprüche 1 bis 7, mit einer Meßvorrichtung für die Klemmenspannung der Batterie, einer Speichervorrichtung für gespeicherte kapazitätsabhängige Kennlinienwerte, einer Vergleichsvorrichtung für die gemessenen Klemmenspannungswerte und die Kennlinienwerte sowie einer Anzeigevorrichtung für den Ladezustand, dadurch gekennzeichnet, daß ein erstes Subtraktionsglied (121) mit ,der gemittelten Klemmenspannung (Um) im Ruhezustand und im Lastzustand der Batterie (100) verbunden ist zur Ermittlung einer Spannungsdifferenz ($\Delta U$), der Ausgang (y1) des ersten Subtraktionsglieds (121) mit einem Eingang (x4) eines weiteren Subtraktionsglieds (122) verbunden ist, dessen anderer Eingang (x3) mit dem Ausgang eines Speichers (130) für die kapazitätsabhängigen Kennlinienwerte verbunden ist, der Ausgang (Y2) des zweiten Subtraktionsglieds mit einem Eingang (A) eines Vergleichers (123) verbunden ist, an dessen anderen Eingang (B) die gemittelte Klemmenspannung (Um) unter Last geschaltet ist, und mit dem Ausgang des Vergleichers (123) eine Steuerschaltung (127, 128) für den Speicher (130) verbunden ist zwecks Ausgabe eines anderen Kennlinienwerts, wenn das Ausgangssignal des Vergleichers (123) ungleich Null ist.

9. Vorrichtung nach Anspruch 8, dadurch gekennzeichnet, daß ein zweiter Vergleicher (140) vorgesehen ist, auf dessen Eingänge (C, D) die nach Lastabschaltung gemessene Klemmenspannung (Ue) und der Ausgang des Speichers (130) für die Kennlinienwerte geschaltet sind, und daß der Ausgang des zweiten Vergleichers (140) ebenfalls mit der Steuerschaltung (127, 128) verbunden ist.

10. Vorrichtung nach Anspruch 8 oder 9, dadurch gekennzeichnet, daß ein dritter Vergleicher (139) vorgesehen ist, auf dessen Eingänge (FE) die gemessene, gemittelte Klemmenspannung (Um) etwa 120 Sekunden nach Lastabschaltung und der Ausgang eines Ruhespannungsspeichers (131) geschaltet sind, wobei im Ruhespannungsspeicher (131) die kapazitätsabhängigen Ruhespannungswerte 120 Sekunden nach Lastabschaltung gespeichert sind und der dritte Vergleicher (139) ebenfalls mit der Steuerschaltung (127, 129) verbunden ist.

11. Vorrichtung nach einem der Ansprüche 8 bis 10, dadurch gekennzeichnet, daß erster und/oder zweiter und/oder dritter Vergleicher (123, 140, 139) jeder drei Ausgänge aufweisen dergestalt, daß ein Signal am ersten Ausgang erscheint, wenn der Signalwert am ersten Eingang (A, C, F) größer als der am zweiten Eingang (B, D, E) ist, ein Signal am dritten Ausgang erscheint, wenn das Signal am ersten Eingang (A, C, F) kleiner als am zweiten Eingang (B, D, E) ist und ein Signal am zweiten Ausgang erscheint, wenn die Signalwerte an den Eingängen (A, B; C, D; F, E) gleich sind, mit dem Ausgang des Vergleichers (123) bzw. der Speicher (123, 140, 139) Häufigkeitszähler (124,125,126) verbunden sind zwecks Ansteuerung der Steuerschaltung (127, 128 bzw. 129) und Ausgabe eines höheren oder eines niedrigen Wertes aus dem Speicher (130 bzw. 131) nach Maßgabe der Häufigkeit der in den Zählern (124, 125, 126) auftretenden Ereignisse.

12. Vorrichtung nach einem der Ansprüche 8 bis 11, dadurch gekennzeichnet, daß die mit der Steuerschaltung verbundene Anzeigevorrichtung (132) den Ladezustand der Batterie (100) in Stufen, 100% bis 0%, und nur in Richtung kleinerer Kapazitätsstufen schaltbar ist.

13. Vorrichtung nach einem der Ansprüche 8 bis 12, dadurch gekennzeichnet, daß der/die Speicher (130) bzw. (131) und/oder die Anzeigevorrichtung (132) durch Schrittschalter (128, 129, 133) ansteuerbar sind.

14. Vorrichtung nach einem der Ansprüche 8 bis 13, dadurch gekennzeichnet, daß der Anzeigevorrichtung (132) eine Anzeigeschaltung und/oder Schaltvorrichtung (141) zugeordnet ist zwecks Anzeige und/oder Abschaltung einer Last, wenn der Ladezustand bzw. die Kapazität einen unteren Wert (20%) erreicht.

## Claims

1. Method for determining the capacity of a lead battery, in which the terminal voltage of the battery is sampled for defined time instants and under different load conditions, and compared with predetermined stored characteric values of the battery voltage in response to capacity, characterized in that the predetermined characteristic values are defined by voltage values (8) which have been determined by trial by measuring the battery voltage shortly after disconnecting a load and in that a measured voltage difference ($\Delta U$) between the terminal voltage before connecting a load and the terminal voltage under load is subtracted from a preselected characteristic value (12a), that the comparison voltage (12) thus produced is compared with a measured voltage value (Um) under load and that for a further measurement another, preferably adjacent characteristic value is selected when the deviation is not equal to zero, wherein the capacity is determined by the capacity value associated to the selected characteristic value.

2. The method of claim 1, characterized in that a plurality of voltage values is measured at intervals of about 100 ms from which voltage values a mean value (Ue or Um) is calculated.

3. The method of claim 1 or 2, characterized in that the voltage difference ($\Delta U$) is changed to the rate of the variation of the load voltage (Um) only then when it exceeds a predetermined threshold value.

4. The method of one of claims 1 to 3, characterized in that the battery capacity is subdivided in capacity steps (100% up to 0%) and the characteristic values are associated to the capacity steps.

5. The method of one of claims 1 to 4, characterized in that those capacity responsive idle voltage values are stored alike which are produced by a measurement 120 s after disconnecting the load and which are

7

compared with idle voltage values (Um) measured 120 s after disconnecting the load, and that a different characteristic value is selected when the deviation is not equal to zero.

6. The method of one of claims 1 to 5, characterized in that the voltage measured after disconnecting the load is compared with stored characteristic values and a different characteristic value is selected when the deviation is not equal to zero.

7. The method of one of claims 1 to 6, characterized in that a first measuring cycle is performed after about 450 s and further measuring cycles are performed after 100s.

8. Apparatus for performing the method of one of claims 1 to 7, comprising a measuring device for the terminal voltage of the battery, a memory means for stored capacity responsive characteric value, a comparison means for the measured terminal voltages and the characteristic values as well as a display means for the capacity, characterized in that a first subtracting stage (121) is connected to the mean terminal voltage (Um) for the idle condition and the load condition of the battery (100) to determine a voltage difference (ΔU), that the output (Y1) of the first substracting stage (121) is connected to an input (X4) of a further subtracting stage (122) which other input (X3) is connected to the output of the memory (130) for the capacity responsive characteristic values, that the output (Y2) of the second subtracting stage is connected to an input (A) of a comparitor (123) to which other input (B) the mean voltage terminal (Um) under load is connected and that a control means (127, 128) for the memory (130) is connected to the output of the comparator (123) for outputing a different characteristic value when the output signal of the comparator (123) is not equal to zero.

9. The apparatus of claim 8, characterized in that a second comparator (140) is provided to which input (CD) the terminal voltage (Ue) measured after disconnecting the load and the output of the memory (130) for the characteristic values are connected, and that the output of the second comparator (140) is connected to the control means (127, 128).

10. The apparatus of claim 8 or 9, characterized in that a third comparator (129) is provided to which inputs (Fe) the measured, mean terminal voltage (Um) is connected about 120 s after disconnecting the load and the output of an idle voltage memory (131), wherein the capacity responsive idle voltage values in the idle voltage memory are stored 120 s after disconnecting the load and that the third comparator (139) is connected to the control means (127, 129).

11. The apparatus of one of claims 8 to 10, characterized in that the first and/or second and/or third comparator (123,140,139) each includes three outputs such that a signal is present on the first output when the signal value of the first input (A,C,F) is larger than the signal of a second input (B,D,E), that a signal is present on the third output when the signal on the first input (A,C,F) is smaller than the signal on the second input (B,D,E), and that a signal is present on the second output, when the signals on the inputs (A,B; C,D; F,E) are equal, that occurency counters (124,125,126) are connected to the output of the comparator (123) or, respectively, the memories (123, 140, 139) to control the control circuitry (127, 128 or 129) and outputting a higher or a lower value from the memory (130 or 131) according to the occurency of the events occurring in the counters (124, 125, 126).

12. The apparatus of one of claim 8 to 11, characterized in that the display means (132) connected to the control means displays the capacity of the battery (100) in steps (100% down to 0%) and that it can be switched only towards smaller capacity steps.

13. The apparatus to one of claims 8 to 12, characterized in that the memory (130) or (131) and/or the display means (132) are controlled by stepping switches (128, 129, 133).

14. The apparatus of one of claims 8 to 13, characterized in that the display means (132) includes an associated display circuitry and/or switching means (141) for displaying and/or disconnecting a load when the capacity reaches a lower value (20%).

## Revendications

1. Procédé de détermination de l'état de charge d'un accumulateur au plomb dans lequel la tension aux bornes de l'accumulateur est relevée à des moments précis et dans différents états de charge et est comparée à des valeurs caractéristiques données, enregistrées, de la tension de l'accumulateur, en fonction de la capacité, caractérisé en ce que les valeurs caractéristiques données sont constituées par des valeurs de tension (8) qui sont déterminées de manière expérimentale en mesurant la tension de l'accumulateur peu après une chute de charge, et en ce que,

une différence de tension (ΔU) mesurée, entre la tension aux bornes avant une application de charge et la tension aux bornes sous charge, est soustrait d'une valeur caractéristique (12a) préalablement choisie, la valeur de tension de référence (12) obtenue étant comparée sous charge à une valeur de tension (Um) mesurée, et en ce que l'on choisit une autre valeur caractéristique, de préférence voisine, lors d'une nouvelle mesure, si l'écart n'est pas nul, l'état de charge étant défini par la valeur de capacité correspondant à la valeur caractéristique choisie.

2.  Procédé selon la revendication 1, caractérisé en ce que l'on mesure à des intervalles d'environ 100 ms, plusieurs valeurs de tension dont on tire une valeur moyenne (Ue ou Um).

3.  Procédé selon la revendication 1 ou 2, caractérisé en ce que la différence de tension (ΔU) n'est modifiée en proportion de la variation de la tension de charge (Um) que si ladite différence est supérieure à une valeur de seuil donnée.

4.  Procédé selon l'une quelconque des revendications 1 à 3, caractérisé en ce que la capacité de l'accumulateur est subdivisée en graduations de capacité (de 100% à 0%) et en ce que les valeurs caractéristiques correspondent aux graduations de la capacité.

5.  Procédé selon l'une quelconque des revendications 1 à 4, caractérisé en ce que sont également enregistrées les valeurs de tension de repos dépendant de la capacité, qui sont obtenues en effectuant une mesure 120 s après la mise hors charge et qui sont comparées à des valeurs de tension de repos (Um) mesurées 120 s après la mise hors charge, et en ce que l'on choisit une autre valeur caractéristique si l'écart n'est pas nul.

6.  Procédé selon l'une quelconque des revendications 1 à 5, caractérisé en ce que la tension mesurée après la mise hors charge est comparée à des valeurs caractéristiques enregistrées, et en ce que l'on choisit une autre valeur caractéristique si l'écart n'est pas nul.

7.  Procédé selon l'une quelconque des revendications 1 à 6, caractérisé en ce qu'un premier cycle de mesures s'opère au bout de 450 secondes environ et que d'autres cycles de mesures se succèdent toutes les 180 secondes.

8.  Dispositif destiné à mettre en oeuvre le procédé selon l'une quelconque des revendications 1 à 7 et comportant un dispositif de mesure de la tension aux bornes de l'accumulateur, un dispositif d'enregistrement des valeurs caractéristiques dépendantes de la capacité, un comparateur des valeurs mesurées de tension aux bornes et des valeurs caractéristiques, et un dispositif d'affichage de l'état de charge, caractérisé en ce qu'un premier membre de soustraction (121) est associé à la tension moyenne aux bornes (Um) lorsque l'accumulateur (100) est à l'état de repos et à l'état sous charge afin de déterminer une différence de tension (ΔU), en ce que la sortie (y1) du premier membre de soustraction (121) est reliée à une entrée (x4) d'un autre membre de soustraction (122), dont l'autre entrée (x3) est reliée à la sortie d'un enregistreur (130) destiné aux valeurs caractéristiques dépendantes de la capacité, en ce que la sortie (Y2) du deuxième membre de soustraction est reliée à une entrée (A) d'un comparateur (123), à l'autre entrée (B) duquel la tension moyenne aux bornes (Um) est commutée sous charge, et en ce qu'un circuit de commande (127, 128) destiné à l'enregistreur est relié à la sortie du comparateur (123) afin d'obtenir une autre valeur caractéristique lorsque le signal de sortie du comparateur (123) n'est pas nul.

9.  Dispositif selon la revendication 8, caractérisé en ce qu'un deuxième comparateur (140) est prévu, sur les entrées (C, D) duquel sont commutées la tension aux bornes (Ue), mesurée après la mise hors charge, et la sortie de l'enregistreur (130), pour les valeurs caractéristiques, et en ce que la sortie du deuxième comparateur (140) est également reliée au circuit de commande (127, 128).

10. Dispositif selon la revendication 8 ou 9, caractérisé en ce qu'un troisième comparateur (139) est prévu, sur les entrées (FE) duquel sont commutées la tension moyenne aux bornes (Um) environ 120 secondes après la mise hors charge, ainsi que la sortie d'un enregistreur de tension au repos (131), les valeurs de tension au repos dépendantes de la capacité étant enregistrées dans l'enregistreur de tension au repos (131) 120 secondes après la mise hors charge, et le troisième comparateur (139) étant également relié au circuit de commande (127, 129).

11. Dispositif selon l'une quelconque des revendications 8 à 10, caractérisé en ce que le premier et/ou le deuxième et/ou le troisième comparateur(s) (123, 140, 139) présente(nt) chacun trois sorties, de configuration telle qu'un signal apparaît à la première sortie lorsque la valeur du signal à la première entrée (A, C, F) est supérieure à la valeur du signal à la deuxième entrée (B, D, E), qu'un signal apparaît à la troisième sortie lorsque le signal à la première entrée (A, C, F) est inférieur au signal à la deuxième entrée (B, D, E), et qu'un signal apparaît à la deuxième sortie lorsque les valeurs de signaux aux entrées (A, B, C, D, E, F) sont identiques, des compteurs de fréquence (124, 125, 126) étant reliés à la sortie du comparateur (123) ou des enregistreurs (123, 140, 139) afin de piloter le circuit de commande (127, 128 ou 129) et de fournir une valeur élevée ou une valeur basse provenant de l'enregistreur (130 ou 131) en fonction de la fréquence des événements se produisant dans les compteurs (124, 125, 126).

12. Dispositif selon l'une quelconque des revendications 8 à 11, caractérisé en ce que le dispositif d'affichage (132) relié au circuit de commande indique l'état de charge de l'accumulateur (100) par graduations de 100% à 0% et ne peut être commuté que dans le sens de graduations de capacité inférieures.

13. Dispositif selon l'une quelconque des revendications 8 à 12, caractérisé en ce que le/les enregistreur(s) (130) ou (131) et/ou le dispositif d'affichage (132) peuvent être pilotés au moyen de commutateurs pas à pas (128, 129, 133).

14. Dispositif selon l'une quelconque des revendications 8 à 13, caractérisé en ce qu'un circuit d'affichage et/ou un dispositif de commutation (141) est associé au dispositif d'affichage (132) afin d'indiquer une charge et/ou d'opérer une mise hors charge lorsque l'état de charge ou la capacité atteignent une valeur basse (20%).

FIG. 1

FIG. 2

## FIG. 3

## FIG. 4

12

FIG. 5

# FIG. 6a

# FIG. 6 b

# FIG. 6c

FIG.7

EP 0 391 106 B1